# EUROPÄISCHE PATENTSCHRIFT

(11) **EP 0 357 699 B1**
(45) Veröffentlichungstag und Bekanntmachung des Hinweises auf die Patenterteilung: **02.11.1994**
(21) Anmeldenummer: 89901268.6
(22) Anmeldetag: 17.01.1989
(51) Int. Cl.: H01J 37/28

(54) **RASTERELEKTRONENMIKROSKOP**
SCANNING ELECTRON MICROSCOPE
MICROSCOPE ELECTRONIQUE A BALAYAGE

(30) Priorität: 29.01.1988 DE 3802598
(43) Veröffentlichungstag der Anmeldung: 14.03.1990
(73) Patentinhaber: Klein, Martin, Dipl.-Ing., D-30989 Gehrden (DE)
(72) Erfinder: Stellmann, Karl, Heinz, W-3057 Neustadt 1 (DE)
(74) Vertreter: Thömen, Uwe, Dipl.-Ing.
(86) Internationale Anmeldenummer: DE8900020
(87) Internationale Veröffentlichungsnummer: WO8907330

(56) Entgegenhaltungen:
- EP-A- 0 057 646
- WO-A-87/04846
- DE-C- 2 635 356
- US-A- 4 460 827
- PATENT ABSTRACTS OF JAPAN, Band 5, Nr. 86 (E-60)(758), 5. Juni 1981 ; & JP-A-56 32 658

## Beschreibung

Die Erfindung betrifft ein Rasterelektronenmikroskop nach dem Oberbegriff des Anspruchs 1.

Rasterelektronenmikroskope bestehen aus einer evakuierbaren Probenkammer mit einer Probenunterlage sowie einer Elektronenoptik, die in die Probenkammer hineinragt, wenigstens einem Detektor und einem außerhalb der Probenkammer befindlichen Monitor. Die Wirkungsweise beruht darauf, daß ein fokussierter Elektronenstrahl auf die zu untersuchende Probe gerichtet und abgelenkt wird, und durch das Auftreffen des Elektronenstrahls aus Atomen der Probe u.a. Sekundärelektronen freisetzt. Die Menge dieser Sekundärelektronen werden mittels einem Elektronendetektor erfaßt und an den Monitor weitergeleitet. Durch die Topologie der Probe kommt es beim Auftreffen und Ablenken des Elektronenstrahls zu unterschiedlichen Austritten von Sekundärelektronen, so daß sich in Abhängigkeit der Topologie ein Intensitätsbild darstellen läßt.

Damit der Elektronenstrahl sich ungehindert ausbreiten kann, wird das Rasterelektronenmikroskop im evakuierten Zustand betrieben. Die Probenkammer läßt sich zu diesem Zweck hermetisch verriegeln und evakuieren.

Neben Anwendungen in der Biologie, Physik, Chemie und Medizin bestehen weitere Anwendungsmöglichkeiten in der Metallurgie und dem Maschinenbau. Gerade in letzteren Bereichen weisen die zu untersuchenden Proben ein sehr hohes Gewicht und große Außenabmessungen auf. Um mehrere Bereiche der Proben nacheinander untersuchen zu können, wird bei bekannten Rasterelektronenmikroskopen, wie bei dem z.B. aus DE-C- 26 35 356 bekannten Rasterelektronenmikroskop, die Probenunterlage als Goniometertisch ausgebildet. Die auf dem Probentisch befestigte Probe kann dann entsprechend verfahren werden, um die Schärfenbereiche für eine hochauflösende Abbildung zu erreichen und unterschiedliche Orte der Probe untersuchen zu können. Ubliche Goniometertische sind in sehr hoher Präzision ausgeführt und für eine Belastbarkeit bis zu 20 kg ausgebildet. Die Belastbarkeit ist dadurch stark eingeschränkt, daß bei üblichen Goniometertischen sehr viele bewegliche Führungselemente und Schlitten vorgesehen sein müssen, die aus Kostengründen nur für eine mäßige Belastung ausgelegt sind.

Befinden sich zum Beispiel die Schlitten der Goniometereinrichtung in einer mittleren Position, also von beiden Endanschlägen maximal entfernt, so ist die Entfernung auf den Führungselementen von deren Einspannorten am größten und damit auch die Instabilität der Goniometereinrichtung am stärksten.

Es hat sich gezeigt, daß das aus den Führungselementen des Goniometertisches sowie dem Gewicht der Probe gebildete Feder-Masse-System eine Resonanzfrequenz annehmen kann, die im Frequenzbereich üblicher Bodenschwingungen liegt. Diese Bodenschwingungen können durch den Straßenverkehr und Produktionsmaschinen im Bereich von Labors und Fabrikanlagen hervorgerufen werden und sind praktisch stets in geringem Maße vorhanden.

Liegt das Feder-Masse-System nun mit seiner Resonanzfrequenz im Bereich der Bodenschwingungen, so vollführt die Probe relativ zu der Elektronenoptik mit den Detektoren Verschiebungen, die bei der gewünschten Auflösung im Nanometerbereich (≦5nm) zu unscharfen Bildern führt und damit die vom System her mögliche Auflösung stark einschränkt.

Der Erfindung liegt die Aufgabe zugrunde, ein Rasterelektronenmikroskop der eingangs genannten Art so zu verbessern, daß auch wesentlich größere und auch schwerere Proben als bisher, vorzugsweise bis zu 100 kg ohne Auflösungsverlust betrachtet werden können.

Diese Aufgabe wird bei einem Rasterelektronenmikroskop nach dem Oberbegriff des Anspruchs 1 durch die im kennzeichnenden Teil angegebenen Merkmale gelöst.

Bei dem Rasterelektronenmikroskop nach der Erfindung wird die Probenunterlage als starrer, ortsfester Probentisch ausgebildet, und dadurch auch zur Aufnahme sehr schwerer, großer Proben geeignet. Die Erzielung der nötigen Stabilität ist ohne großen Aufwand durchführbar.

Um die nötigen Einstellungen der Schärfe und das Anfahren der gewünschten Beobachtungsorte zu ermöglichen, ist nunmehr die Elektronenoptik vollständig im Inneren der Probenkammer angeordnet und damit beweglich. Sie und die Detektoren sind in der Goniometereinrichtung, die hier als Halterung ausgebildet ist, aufgenommen. Mittels der Goniometerhalterung kann also die Elektronenoptik mit den Detektoren statt der Probe verfahren werden. Da das Gewicht der Elektronenoptik mitsamt den Detektoren konstant ist, läßt sich die Goniometerhalterung zuverlässig so bemessen, daß Bodenschwingungen zu keiner Relativbewegung zwischen Elektronenoptik und Probe mehr führen. Aufgrund des Gewichtes von ca. 10 - 20 kg der Elektronenoptik mitsamt den Detektoren kann die Goniometereinrichtung auch konventionell ausgebildet sein. Daher kann der Antrieb der Goniometeranordnung auch einfach und leistungsparend aufgebaut sein.

Darüberhinaus ist die Beweglichkeit innerhalb der Probenkammer wesentlich größer als bei einem zu Zwecken der erforderlichen Stabilität klobigen Ausbau der Goniometereinrichtung.

Die Bewegungsmöglichkeiten der Goniometereinrichtung gestatten es, ohne Verlagerung der Probe praktisch alle in Frage kommenden Orte auf der Probe anzufahren und zu beobachten. Dabei ist auch eine Betrachtung unter extrem unterschiedlichen Blickwinkeln möglich.

Vorzugsweise ist die Goniometerhalterung an der Rückwand der Probenkammer befestigt.

Bei dieser Maßnahme wird die aufgrund ihrer Widerstandsfähigkeit gegen den Ausdruck im evakuierten Zustand erforderliche Stabilität zur Stabilisierung der Goniometerhalterung ausgenutzt. Diese ist damit wenigstens in der ersten Ebene als praktisch starr anzusehen.

Eine Weiterbildung sieht vor, daß die Detektoren um eine erste, durch die Elektronenstrahlachse der Elektronenoptik führende Schwenkachse und um eine zweite, die Elektronenstrahlachse im rechten Winkel schneidende Schwenkachse schwenkbar sind.

Diese Ausgestaltung ermöglicht es, neben einer Änderung des Einfallswinkels für den Elektronenstrahl, der bereits die Erzielung unterschiedlicher Blickwinkel ermöglicht, auch noch weitere Variationen des Blickwinkels auszunutzen um so eine noch bessere Darstellung der Topologie bzw. der Zusammensetzung der Probe zu erhalten.

Dabei ist der Schwenkbereich der Detektoren um die erste Achse wenigstens 270° bemessen und um die zweite Achse vorzugsweise zwischen einem Winkel von 20° bis 75° zur Elektronenstrahlachse veränderbar.

Diese Bemessung der Schwenkbereiche hat sich als ausreichend erwiesen und stellt gleichzeitig einen guten Kompromiß hinsichtlich des Aufwandes bei den Führungselementen dar.

Bei einer praktischen Ausgestaltung sind die Detektoren auf einer kreisringabschnittförmigen Winkelführungsbahn angeordnet, die ihrerseits an einer Schwenkhülse befestigt ist, welche schwenkbeweglich die Elektronenoptik umgreift.

Die beschriebene Ausgestaltung ermöglicht es, die Schwenkbeweglichkeit um die Elektronenstrahlachse mit derjenigen um eine senkrecht zur Elektronenstrahlachse führenden Achse zu kombinieren. Dabei befinden sich die Führungselemente außerhalb des Schwenkbereichs der Goniometerhalterung, so daß dieser voll ausgenutzt werden kann.

Bei einer praktischen Ausgestaltung bildet die Elektronenoptik mit den Detektoren und der Goniometerhalterung ein Feder-Masse-System, deren Resonanzfrequenz weit außerhalb des Bereiches von Bodenschwingungen liegt.

Eine Weiterbildung sieht vor, daß ein die Detektoren auf der Winkelführungsbahn führender Schlitten sowie die Schwenkhülse oder die Elektronenoptik jeweils einen auf einen Zahnkranz mittels Ritzel eingreifenden Antriebsmotor aufweisen.

Damit ist auch die Einstellung der Detektoren durch Fernsteuerung möglich und während des Betriebes des Elektronenmikroskops unter Vakuum veränderbar. Die verschiedenen Einstellungen können unter gleichzeitiger Beobachtung des mikroskopischen Bildes vorgenommen werden um so eine optimale Einstellung zu finden.

Bei einer praktischen Ausgestaltung weist die Probenkammer ein Volumen von ca. 1 m³ und größer auf.

Bei diesem Volumen können einmal Probekörper in der von ihrem Verwendungszweck bestimmten Größe ohne Schwierigkeiten angeordnet werden, zum anderen ist auch ein ausreichender Verschiebungs- und Schwenkbereich der Goniometerhalterung innerhalb der Probenkammer gegeben.

Durch einfache Ausgestaltung des Probentisches läßt sich erzielen, daß dessen Tragfähigkeit mehr als 100 kg beträgt. Die Systeme verhalten sich praktisch starr, so daß Schwingungen mit einer niedrigeren Frequenz eine gleichzeitige Verschiebung der Probe sowie der Elektronenopitk und der Detektoren bewirken, so daß sich keine Relativbewegung zwischen Probe und Elektronenoptik ergibt. Dadurch lassen sich die von der Feinbündelung der Elektronenstrahlen abhängigen Auflösungen ohne weiteres erreichen.

Weiterbildunqen und vorteilhafte Ausgestaltungen der Erfindung ergeben sich aus den Ansprüchen, der Beschreibung und der Zeichnung, die ein Ausführungsbeispiel der Erfindung veranschaulicht.

Ein Ausführungsbeispiel der Erfindung wird an Hand der Zeichnung erläutert. In der Zeichnung zeigen:
- Fig. 1: eine perspektivische Ansicht eines Rasterelektronenmikroskops,
- Fig. 2: als vergrößerte Einzelheit die in der Probenkammer angeordneten Einrichtungen und
- Fig. 3: als weitere Einzelheit die Elektronenoptik und die dazu schwenkbeweglich verstellbaren Detektoren.

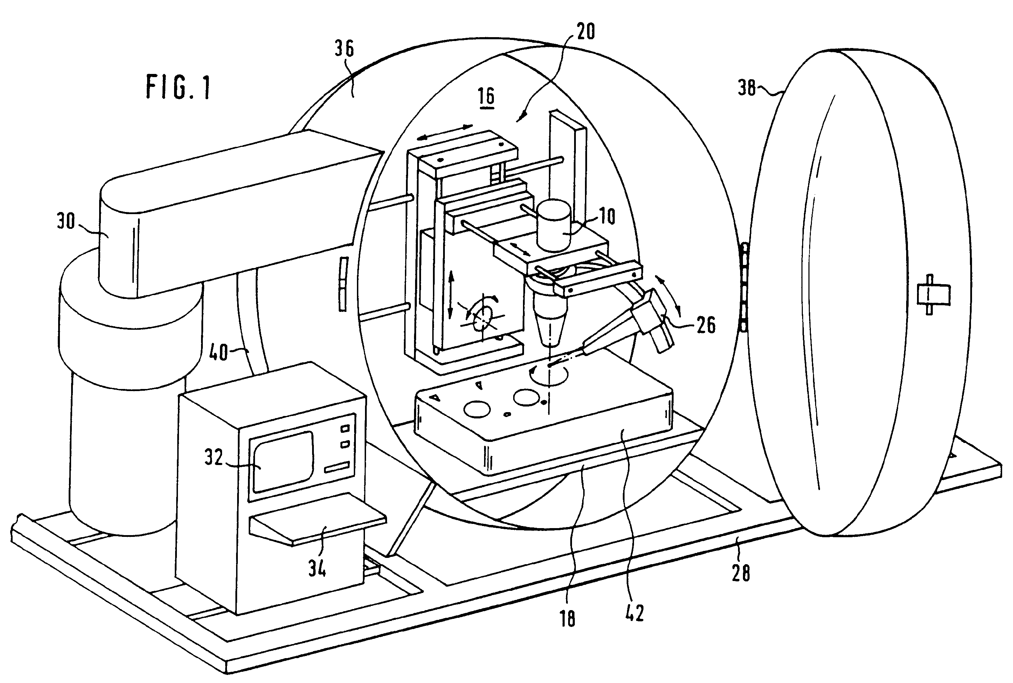

Das in Fig. 1 dargestellte Rasterelektronenmikroskop umfaßt ein fahrbares Grundgestell 28, auf dem eine evakuierbare Probenkammer 16, eine Evarkuiervorrichtung 30 sowie ein Monitor 32 mit einem Steuergerät 34 angeordnet sind. Die Probenkammer 16 besitzt eine zylindrische Mantelfläche 36 und vorzugsweise gewölbte Stirnflächen 38 und 40. Die vordere Stirnfläche 38 ist als Tür ausgebildet. Die hintere Stirnfläche 40, also die Rückwand der Probenkammer 16 dient gleichzeitig zur Befestigung einer Goniometerhalterung 20 im Inneren der Probenkammer 16. Damit wird die wegen der Überdruckfestigkeit benötigte Steifigkeit der Rückwand 40 zur Aussteifung der Goniometerhalterung 20 mit verwendet.

Die Goniometerhalterung 20 nimmt eine Elektronenoptik 10 sowie Detektoren 12 und 14 auf. Außerdem enthält die Probenkammer 16 noch einen ortsfesten Probentisch 18. Das Volumen der Probenkammer 16 beträgt etwa 1 m³ die Höhe ist auf ca. 1,40 m bemessen. In dieser Ausgestaltung ist die Probenkammer 16 auch für große Proben geeignet, wie sie z.B. bei der zerstörungsfreien Materialprüfung von Werkzeugen oder Maschinenaggregaten vorkommen. Als Beispiel sind hier mit ausgewuchtetem Flanschteil versehene Schleifscheiben mit 500 mm Durchmesser und 40 kg Gewicht oder Motorblöcke zu nennen.

Durch die ortsfeste Anordnung des Probentisches 18 im unteren Bereich der Probenkammer 16 läßt sich die Stabilität ihrer Mantelfläche 36, die wegen des Außendrucks im evakuierten Zustand erforderlich ist, zusätzlich zur Festlegung des Probentisches 18 ausnutzen. Der Probentisch 18 erhält so eine außerordentlich starre Befestigung.

Durch die Anordnung der Elektronenoptik 10 und der Detektoren 12 und 14 in der Goniometerhalterung 20 läßt sich auch dieses Feder-Masse-System mit einfachen Mitteln so auslegen, daß seine Resonanzfrequenz oberhalb der Frequenz üblicher Bodenschingungen zu liegen kommt. Die geeignete Auslegung wird dadurch möglich, daß entgegen üblicher Goniometeranordnungen bei Rasterelektronenmikroskopen die Masse hier im wesentlichen von der Elektronenoptik 10 und den Detektoren 12 und 14 gebildet ist und diese konstant ist. Außerdem ist die Masse geringer als diejenige großer Proben für die das Rasterelektronenmikroskop verwendet werden soll.

Wenn auch die Steifigkeit der Goniometerhalterung 20 geringer ist als die des Probentisches 18, so ergibt sich aufgrund der geringeren Masse der Elektronenoptik 10 mitsamt den Detektoren 12 und 14 dennoch eine ausreichend hohe Resonanzfrequenz. Ist die Probenkammer 16 im Betrieb Bodenschwingungen ausgesetzt, so teilen sich diese zwar auch dem aus dem Probentisch 18 und der Probe 42 einerseits sowie der Goniometerhalterung 20 mitsamt der Elektronenoptik 10 und den Detektoren 12 und 14 andererseits gebildeten Feder-Masse-Systemen mit. Die beiden Feder-Masse-Systeme schwingen aber gleichphasig und vollführen keine Relativbewegungen zueinander, die Ursache für Unschärfen bei der Betrachtung großer, schwerer Proben ist. Das erfindungsgemäße Rasterelektronenmikroskop kann die systembedingte Vergrößerung von mehr als 1 : 4000 auch bei großen, schweren Proben erreichen.

Neben der erheblichen Verbesserung des Auflösungsvermögens, bezogen auf sehr große Proben, die von der mechanischen Ausgestaltung praktisch ohne Mehraufwand gegenüber üblichen Rasterelektronenmikroskopen erzielt wird, besitzt die Anordnung der Elektronenoptik 10 und der Detektoren 12 und 14 in der Goniometerhalterung 20 auch den Vorteil, daß alle seitlichen und oberen Bereiche der Probe 42 zur Beobachtung angefahren werden können. Dies ist möglich, ohne daß die Lage der Probe 42 verändert werden muß. Auf diese Weise wird auch der Randbereich zur Beobachtung zugänglich, was nicht der Fall wäre, wenn bei stationärer Elektronenopitk 10 die Probe 42 verfahren werden müßte. Diese würde dann nämlich schon nach einem kurzen Verschiebeweg mit ihrer dem gewünschten Beobachtungsort gegenüberliegenden Seite an die Wand der Probenkammer 16 anstoßen.

Zur besseren Übersicht sind in Fig. 1 die erforderlichen Steuer-, Energieversorgungs- und Datenleitungen fortgelassen. Diese Leitungen sind hermetisch abdichtend durch die Mantelfläche 36 der Probenkammer 16 geführt und verbinden die Elektronenoptik 10 sowie die Antriebsorgane der Goniometerhalterung 20 mit dem Steuergerät 34 und die Detektoren 12 und 14 mit dem Monitor.

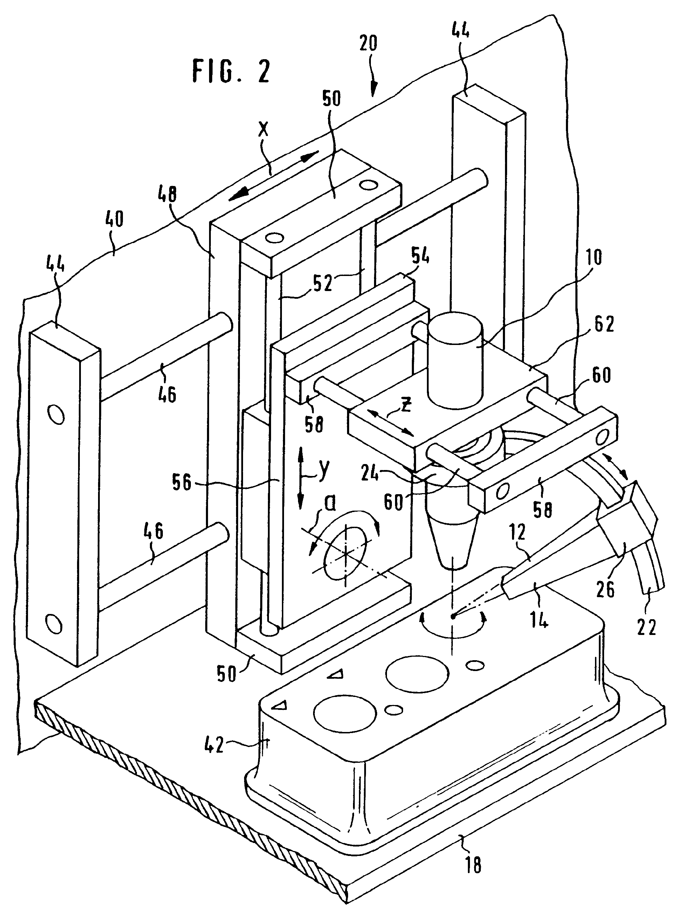

Zur näheren Erläuterung der die Elektronenopitk 10 und die Detektoren 12 und 14 aufnehmenden Goniometerhalterung 20 wird auf Fig. 2 Bezug genommen. Die Goniometerhalterung 20 weist ein erstes Trägerpaar 44 auf, das an der Rückwand 40 der Probenkammer 16 befestigt ist. Zwischen diesem Trägerpaar 44 ist ein erstes Paar Führungsschienen 46 angeordnet, auf dem eine Führungsplatte 48 verschiebbar gelagert ist.

Zum Transport der Führungsplatte 48 dient eine nicht dargestellte, mit einem Antrieb verbundene Gewindespindel. Die Gewindespindel wäre parallel zu dem ersten Paar Führungsschienen 46 anzuordnen und müßte die Führungsplatte 48 durchgreifen. Die bislang beschriebenen Teile sind waagerecht angeordnet und erlauben eine Verschiebung der Führungsplatte 48 in Richtung des Freiheitsgrades x.

Auf der Führungsplatte 48 ist ein zweites Trägerpaar 50 angeordnet, zwischen dem sich ein zweites Paar Führungsschienen 52 erstreckt. Auf dem zweiten Paar Führungsschienen 52 wiederum ist eine zweite Führungsplatte 54 verschiebbar gelagert. Die Verschiebungsrichtung weist in Richtung des Freiheitsgrades y. Auch hier dient wieder zum Transport eine nicht dargestellte, mit einem Antrieb versehen Gewindespindel, die analog dem ersten Antrieb parallel zu dem zweiten Paar Führungsschienen ausgerichtet sein müßte und die zweite Führungsplatte 54 durchgreifen müßte.

Mit der zweiten Führungsplatte 54 ist eine Trägerplatte 56 schwenkbar verbunden. Die Schwenkachse a bildet hier einen weiteren Freiheitsgrad. Ein nicht dargestellter Antrieb ermöglicht die Einstellung der gewünschten Schwenkstellung.

Auf der Trägerplatte 56 ist ein erster Teil eines dritten Trägerpaares 58 befestigt, von dem ein drittes Paar Führungsschienen 60 ausgehen. Der zweite Teil des dritten Trägerpaares 58 ragt freitragend nach vorne und hält lediglich das dritte Paar Führungsschienen 60 an seinem freien Ende auf Abstand. Das dritte Paar Führungsschienen 60 steht senkrecht auf der Trägerplatte 56 und lagert eine verschiebbare Halteplatte 62. Die Halteplatte 62 kann in Richtung des Freiheitsgrades z verschoben werden. Auch diese Halteplatte 62 läßt sich durch eine nicht dargestellte, mit einem Antrieb verbundene Gewindestange transportieren.

In der Halteplatte 62 ist die Elektronenopitk 10 angeordnet, wobei der obere zylindrische Teil der Elektonenoptik 10 die in der Grundstellung waagerechte Halteplatte 62 durchgreift, so daß die Elektronenoptik 10 etwa in einem Bereich zwischen der Mitte und dem oberen Drittel umschlossen ist. Die Elektronenoptik 10 ist unterhalb der Halteplatte 62 von einer Schwenkhülse 24 umgeben, an der eine Winkelführungsbahn 22 angeordnet ist.

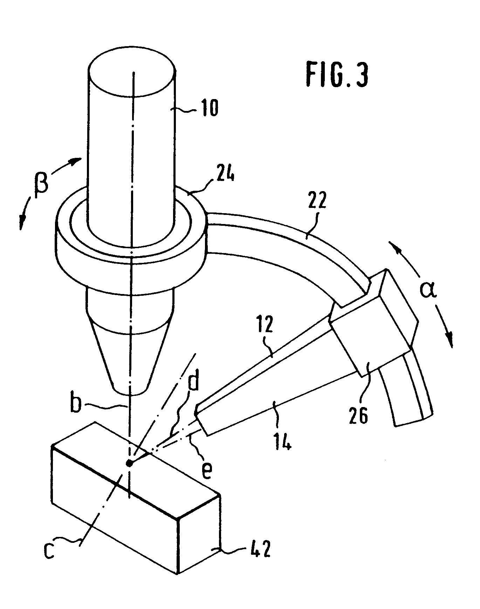

Zur Erläuterung der Ausgestaltung wird auf Fig. 3 Bezug genommen. Wie die Zeichnung erkennen läßt, ist auf der Winkelführungsbahn 22 ein Schlitten 26 verschiebbar angeordnet, an dem wiederum die Detektoren 12 und 14 befestigt sind. Bei den Detektoren handelt es sich um einen Szintilator 12 und einen Halbleiterdetektor für ein Energiedispersives Spektrometer (EDS) 14. Mit dem Szintilator 12 kann die Menge der emittierten Sekundärelektronen gemessen werden, welche abhängig vom Probenmaterial und Lage der Probe zum Elektronenstrahl ist und u.a. eine Wiedergabe der Topographie der Probe 42 ermöglicht. Mit dem Energiedispersiv-Spektrometer 14 kann die Materialzusammensetzung der Probe 42 bestimmt werden, sowohl qualitativ als auch quantitativ.

Beide Detektoren 12 und 14 besitzen Achsen d und e, welche die Achse des Primärelektronenstrahls der Elektronenoptik 10 schneiden. Bei bekannten Rasterelektronenmikroskopen waren die Winkel zwischen den optischen Achsen der Detektoren und des Primärelektronenstrahls fest eingestellt. Durch die Winkelführungsbahn 22 können die Detektoren 12 und 14 geschwenkt werden, und zwar um eine Achse c, welche senkrecht auf der Achse des Primärelektronenstrahls durch die Elektronenoptik 10 steht und diese Schnittpunkt mit den optischen Achsen der Detektoren 12 und 14 schneidet. Die Schwenkmöglichkeit gestattet es, Proben 42 unter unterschiedlichen Blickwinkeln zu betrachten. Ein für praktische Anwendungen sinnvoller Schwenkbereich liegt in einem Winkelbereich α zwischen 20° und 75° der Achsen d und e zur Achse des Elektronenstrahls der Elektronenoptik 10. Der weitere Schwenkbereich um eine durch den Elektronenstrahl der Elektronenoptik 10 laufenden Schwenkachse a ist auf einen Schwenkwinkel β von mindestens 270° bemessen.

Sowohl die Schwenkhülse 24 auf der Elektronenoptik 10 als auch der Schlitten 26 auf der Winkelführungsbahn 22 sind mit Antrieben versehen, um die unterschiedlichen Winkelpositionen ferngesteuert anfahren zu können. Im vorliegenden Fall erfolgen die Antriebe über nicht dargestellte Antriebsmotore, welche mittels Ritzel in Zahnkränze eingreifen.

Die beschriebenen Eigenschaften des Rasterelektronenmikroskops kommen besonders dann zum Tragen, wenn große Proben mit komplizierter Oberflächenstruktur betrachtet werden sollen, wie es z.B. bei dem in Fig. 1 und 2 dargestellten Motorblock als Probe 42 der Fall ist. Um die Zylinderlaufbuchsen auch in einem weiter im Inneren des Motorblocks liegenden Bereich betrachten zu können, ist eine vielseitige Einstellungsmöglichkeit und große ungestörte Beweglichkeit der Elektronenoptik mitsamt den Detektoren erforderlich, wie sie erst durch die Merkmale der Erfindung erreicht wird.

Die Goniometereinrichtung 20 läßt sich übrigens nicht nur in Form eines üblichen Goniometertisches realisieren; es ist auch möglich, einen Roboterarm oder dgl. zur Halterung der Elektronenoptik zu verwenden.

## Patentansprüche

1. Rasterelektronenmikroskop, welches eine Elektronenoptik (10), Detektoren (12, 14) und eine evakuierbare Probenkammer (16) mit einer Probenunterlage (18) und einer Goniometereinrichtung (20) umfaßt, dadurch gekennzeichnet, daß sich die Elektronenoptik (10) vollständig im Inneren der Probenkammer (16) befindet, daß die Goniometereinrichtung als Halterung (20) ausgebildet ist und die Elektronenoptik (10) mitsamt den Detektoren (12, 14) aufnimmt und daß die Probenunterlage als starrer, ortsfester Probentisch (18) ausgebildet ist.

2. Rasterelektronenmikroskop nach Anspruch 1, dadurch gekennzeichnet, daß die Goniometerhalterung (20) in drei senkrecht aufeinanderstehenden Freiheitsgraden (x, y, z) längsverschiebbar und um eine waagerechte Achse (a) schwenkbar ausgebildet ist.

3. Rasterelektronenmikroskop nach Anspruch 1 oder 2, dadurch gekennzeichnet, daß die Goniometerhalterung (20) an der Rückwand der Probenkammer (16) befestigt ist.

4. Rasterelektronenmikroskop nach einem oder mehreren der Ansprüche 1 - 3, dadurch gekennzeichnet, daß die Detektoren (12, 14) um eine erste, durch die Elektronenstrahlachse der Elektronenoptik (10) führende Schwenkachse (b) und um eine zweite, die Elektronenstrahlachse im rechten Winkel schneidende Schwenkachse (c) schwenkbar sind.

5. Rasterelektronenmikroskop nach einem oder mehreren der Ansprüche 1 - 4, dadurch gekennzeichnet, daß der Schwenkbereich der Detektoren (12, 14) um die erste Achse (b) wenigstens 270° und um die zweite Achse (c) vorzugsweise zwischen einem Winkel von 20° bis 75° zur Elektronenstrahlachse beträgt.

6. Rasterelektronenmikroskop nach einem oder mehreren der Ansprüche 1 - 5, dadurch gekennzeichnet, daß die Detektoren (12, 14) auf einer kreisringabschnittförmigen Winkelführungsbahn (22) angeordnet sind, die ihrerseits in einer Schwenkhülse (24) befestigt ist, welche schwenkbeweglich die Elektronenoptik (10) umgreift.

7. Rasterelektronenmikroskop nach einem oder mehreren der Ansprüche 1 - 6, dadurch gekennzeichnet, daß die Elektronenoptik (10) mit den Detektoren (12, 14) und der Goniometerhalterung (20) ein Feder-Masse-System bildet, dessen Resonanzfrequenz weit außerhalb des Bereichs von Bodenschwingungen liegt.

8. Rasterelektronenmikroskop nach einem oder mehreren der Ansprüche 1 - 7, dadurch gekennzeichnet, daß ein die Detektoren (12, 14) auf der Winkelführungsbahn (22) führender Schlitten (26) sowie die Schwenkhülse (24) oder die Elektronenoptik (10) jeweils einen auf einen Zahnkranz mittels Ritzel eingreifenden Antriebsmotor aufweisen.

9. Rasterelektronenmikroskop nach einem oder mehreren der Ansprüche 1 - 8, dadurch gekennzeichnet, daß die Probenkammer (16) ein Volumen von größer 1 m³ aufweist.

10. Rasterelektronenmikroskop nach einem oder mehreren der Ansprüche 1 - 9, dadurch gekennzeichnet, daß der Probentisch (18) eine Tragfähigkeit von wenigstens 100 kg aufweist und ein Feder-Masse-System bildet, dessen Resonanzfrequenz auch bei maximaler Belastung weit außerhalb des Frequenzbereichs von Bodenschwingungen liegt.

## Claims

1. Scanning electron microscope, which comprises an electron optics (10), detectors (12, 14) and an evacuatable sample chamber (16) with a sample substrate (18) and a goniometer means (20), characterized in that the electron optics (10) is completely located in the interior of the sample chamber (16), that the goniometer means is constructed as a mounting support (20) and receives the electron optics (10) together with the detectors (12, 14) and that the sample substrate is constructed as a rigid, fixed sample table (18).

2. Scanning electron microscope according to claim 1, characterized in that the goniometer mounting support (20) is longitudinally displaceable in three mutually orthogonal degrees of freedom (x, y, z) and is constructed so as to pivot about a horizontal axis (a).

3. Scanning electron microscope according to claim 1 or 2, characterized in that the goniometer mounting support (20) is fixed to the rear wall of the sample chamber (16).

4. Scanning electron microscope according to one or more of the claims 1 to 3, characterized in that the detectors (12, 14) are pivotable about a first pivot axis (b) passing through the electron beam axis of the electron optics (10) and about a second pivot axis (c) intersecting at right angles the electron beam axis.

5. Scanning electron microscope according to one or more of the claims 1 to 4, characterized in that the pivoting range of the detectors (12, 14) about the first axis (b) is at least 270° and about the second axis (c) is preferably between an angle of 20 to 75° to the electron beam axis.

6. Scanning electron microscope according to one or more of the claims 1 to 5, characterized in that the detectors (12, 14) are located on a circular ring sector-like angle guidance path (22), which is in turn fixed in a rotating sleeve (24), which pivots round the electron optics (10).

7. Scanning electron microscope according to one or more of the claims 1 to 6, characterized in that the electron optics (10) with the detectors (12, 14) and the goniometer mounting support (20) forms a spring-mass system, whose resonant frequency is well below the fundamental oscillation range.

8. Scanning electron microscope according to one or more of the claims 1 to 7, characterized in that a slide (26) guiding the detector (12) on the angle guidance path (22), as well as the rotating sleeve (24) or the electron optics (10) in each case have a drive motor engaging on a toothed wheel by means of a pinion.

9. Scanning electron microscope according to one or more of the claims 1 to 8, characterized in that the sample chamber (16) has a volume greater than 1 m³.

10. Scanning electron microscope according to one or more of the claims 1 to 9, characterized in that the sample table (18) has a load carrying capacity of at least 100 kg and forms a springmass system, whose resonant frequency, even under maximum load, is well outside the frequency range of the fundamental oscillations.

## Revendications

1. Microscope électronique à balayage qui comprend une optique électronique (10), des détecteurs (12, 14) et une chambre d'échantillons (16), qui peut être mise sous vide, avec un support d'échantillons (18) et un dispositif de goniométrie (20), caractérisé en ce que l'optique électronique (10) se trouve complètement à l'intérieur de la chambre d'échantillons (16), en ce que le dispositif de goniométrie a la forme d'une suspension (20) et porte l'optique électronique (10) avec les détecteurs (12, 14), et en ce que le support d'échantillons a la forme d'une platine d'échantillons (18) rigide et fixe.

2. Microscope électronique à balayage suivant la revendication 1, caractérisé en ce que la suspension goniométrique (20) est prévue déplaçable longitudinalement suivant trois degrés de liberté (x, y, z), perpendiculaires entre eux, et est orientable autour d'un axe horizontal (a).

3. Microscope électronique à balayage suivant la revendication 1 ou 2, caractérisé en ce que la suspension goniométrique (20) est fixée à la paroi arrière de la chambre d'échantillons (16).

4. Microscope électronique à balayage suivant une ou plusieurs des revendications 1 à 3, caractérisé en ce que les détecteurs (12, 14) sont orientables autour d'un premier axe d'orientation (b) dirigé suivant l'axe des rayons électroniques de l'optique électronique (10) et autour d'un second axe d'orientation (c) coupant à angle droit l'axe des rayons électroniques.

5. Microscope électronique à balayage suivant une ou plusieurs des revendications 1 à 4, caractérisé en ce que la plage d'orientation des détecteurs (12, 14) est, autour du premier axe (b), d'au moins 270° et, autour du deuxième axe (c), de préférence comprise entre un angle de 20° jusqu'à 75° par rapport à l'axe des rayons électroniques.

6. Microscope électronique à balayage suivant une ou plusieurs des revendications 1 à 5, caractérisé en ce que les détécteurs (12, 14) sont montés sur un rail de guidage angulaire (22) en forme d'arc de cercle qui, d'un côté, est fixé dans un manchon pivotant (24) qui entoure mobile l'optique électronique (10) et peut pivoter.

7. Microscope électronique à balayage suivant une ou plusieurs des revendications 1 à 6, caractérisé en ce que l'optique électronique (10), avec les détecteurs (12, 14) et la suspension goniométrique (20), forment un système masse-ressort dont la fréquence de résonance est largement hors de la plage de vibrations du sol.

8. Microscope électronique à balayage suivant une ou plusieurs des revendications 1 à 7, caractérisé en ce qu'un coulisseau (26) qui guide les détecteurs (12, 14) sur le rail de guidage angulaire (22), ainsi que le manchon orientable (24) ou l'optique électronique (10), comportent respectivement un moteur d'entraînement engrenant une couronne dentée au moyen de pignon.

9. Microscope électronique à balayage suivant une ou plusieurs des revendications 1 à 8, caractérisé en ce que la chambre d'échantillons (16) a un volume de plus de 1 m³.

10. Microscope électronique à balayage suivant une ou plusieurs des revendications 1 à 9, caractérisé en ce que la platine d'échantillons (18) a une force portante d'au moins 100 kg et forme un système masse-ressort dont la fréquence de résonance est, en charge maximale, également largement en dehors de la plage des fréquences de vibrations du sol.
